# EUROPEAN PATENT APPLICATION

(11) **EP 3 978 646 A1**
(43) Date of publication of application: **06.04.2022**
(21) Application number: 20819394.6
(22) Date of filing: 02.06.2020
(51) Int. Cl.: C23C 16/22, C23C 16/56, C23C 16/50, C23C 16/448, H01L 31/032, H01L 31/0256

(54) **METHOD FOR PREPARING PEROVSKITE SOLAR CELL ABSORBING LAYER BY MEANS OF CHEMICAL VAPOR DEPOSITION**

(30) Priority: 03.06.2019 KR 20190065460; 01.06.2020 KR 20200065672
(71) Applicant: Mecaroenergy Co., Ltd., Chungcheongbuk-do 27721 (KR)
(72) Inventor: JANG, Hyuk Kyoo, Seongnam-si, Gyeonggi-do 13626 (KR); LEE, So Yeon, Cheongju-si, Chungcheongbuk-do 28113 (KR); LEE, Gyu Hyun, Chungju-si, Chungcheongbuk-do 27341 (KR)
(74) Representative: Keil & Schaafhausen Patentanwälte PartGmbB
(86) International application number: PCT/KR2020/007105
(87) International publication number: WO 2020/246764

(57) **Abstract**

Disclosed is a method for preparing the light absorption layer of a perovskite solar cell using the chemical vapor deposition (CVD) method. The method for preparing the light absorption layer of a perovskite solar cell using the chemical vapor deposition (CVD) method includes forming a PbIₓ thin film on a substrate by means of chemical vapor deposition; supplying methylamine and an iodine (I) precursor on the PbIₓ (1≤x≤2) thin film and forming a CH₃NH₃PbI₃ thin film having a perovskite structure through heat treatment.

## Description

### TECHNICAL FIELD

The present invention relates to a solar cell, and more particularly to a method for preparing a light absorption layer for perovskite solar cells using chemical vapor deposition.

### BACKGROUND ART

A solar cell is a device that converts solar energy into electrical energy. The currently commercialized solar cells are mostly silicon solar cells that use a crystalline silicon substrate and occupy more than 80% of the total market.

But, the silicon solar cell has a limit in reducing the production cost because the price of the substrate accounting for too much of the product price and the necessity of using a complicated production process.

In order to overcome this problem, there have been developed various types of thin film solar cells, such as CdTe, CIGS, and DSSC. As one of the new thin film solar cells, the perovskite solar cell is being actively developed.

When it comes to the studies on the perovskite solar cells, it is known that energy conversion efficiency of 20% or higher has been achieved at the laboratory level thanks to the development of many research groups.

The solution method such as spin coating is most commonly used as a method for preparing a light absorption layer of the perovskite solar cell. The preparation method for perovskite solar cells using the solution method is a non-vacuum method, so it has advantages of low production cost and easy implementation. Yet, it also has a disadvantage in that large-area solar cells are difficult to implement due to poor uniformity of the deposited thin film.

Besides, the conventional solution method is disadvantageous in that there are a number of pinholes in the perovskite thin film to be deposited, thereby deteriorating the quality of the solar cell.

### SUMMARY OF THE DISCLOSURE

It is therefore an object of the present invention to provide a method for preparing a perovskite light absorption layer using chemical vapor deposition (CVD).

It is another object of the present invention to provide a method for preparing a solar cell that can improve the uniformity of the thin film to enable the production of a large-area solar cell and enhance the quality of the thin film to increase the efficiency of the solar cell.

In accordance with one aspect of the present invention for achieving the objects, there is provided a method for preparing a perovskite solar cell absorbing layer that is a method for preparing a perovskite solar cell light absorbing layer using chemical vapor deposition (CVD), where the method includes: forming a PbIₓ thin film on a substrate by means of chemical vapor deposition; supplying CH₃NH₂ (methylamine) gas and an iodine precursor on the PbIₓ (1≤x≤2) thin film; and forming a CH₃NH₃PbI₃ thin film having a perovskite structure through heat treatment after the supplying of the CH₃NH₂ (methylamine) gas and the iodine precursor on the PbIₓ (1≤x≤2) thin film.

In an embodiment, the forming of the PbIₓ thin film may include using, as a lead (Pb) precursor, tetraethyl-lead, tetramethyl-lead, acetylacetonate-lead(II), and bis(2,2,6,6-tetramethyl-3,5-herptanedionate) lead(II).

In an embodiment, the forming of the PbIₓ thin film may include using, as an iodine (I) precursor, iodine (I₂), 6-iodo-1-hexyne, tertiary-butyl iodide, isopropyl iodide, and ethyl iodide.

In an embodiment, the forming of the PbIₓ thin film may include supplying the Pb precursor and the I precursor into a reaction chamber in simultaneous or sequential manner.

In an embodiment, the forming of the PbIₓ thin film may include maintaining a canister temperature for the Pb precursor or I precursor in the range of -20 to 100 °C.

In an embodiment, the forming of the PbIₓ thin film may include maintaining the temperature of a precursor supply line for supplying the Pb precursor or I precursor in the range from a room temperature to 200 °C.

In an embodiment, forming of the PbIₓ thin film may include maintaining a temperature of a substrate for the Pb precursor or I precursor deposited thereon in the range of 50 to 300 °C.

In an embodiment, the forming of the PbIₓ thin film may include using a carrier gas in supplying the Pb precursor or I precursor into the reaction chamber, where the carrier gas may be any one of argon (Ar), helium (He) or nitrogen (N₂), or a mixture thereof.

In an embodiment, the forming of the PbIₓ thin film may include maintaining an internal pressure of the reaction chamber in the range of 1 mTorr to 100 Torr.

In an embodiment, the forming of the PbIₓ thin film may include using plasma in order to increase the deposition rate and quality of a thin film.

In an embodiment, the forming of the CH₃NH₃PbI₃ thin film may include maintaining a temperature atmosphere of a supply line of MA (methylamine, CH₃NH₂) and an iodine precursor in the range from a room temperature to 200 °C.

In an embodiment, the forming of the CH₃NH₃PbI₃ thin film may include maintaining a temperature atomosphere of a substrate for MA (methylamine, CH₃NH₂) and an iodine precursor supplied thereto in the range from a room temperature to 250 °C.

In an embodiment, the forming of the CH₃NH₃PbI₃ thin film may include conducting a heat treatment at a temperature of 100 to 300 °C on the CH₃NH₃PbI₃ thin film deposited through the supplying of the CH₃NH₂ (methylamine) gas and the iodine precursor on the PbIₓ (1≤x≤2) thin film.

In an embodiment, the forming of the CH₃NH₃PbI₃ thin film may include conducting a heat treatment under vacuum or in one or more gas atmospheres of argon (Ar), nitrogen (N₂), hydrogen (H₂), or helium (He).

The use of the above-described method for preparing a perovskite solar cell absorbing layer using the chemical vapor deposition (CVD) has beneficial effects to facilitate the implementation of large-area solar cells and use inorganic materials as CVD precursors, which can minimize an issue of deterioration in efficiency over time after the preparation of solar cells. Another beneficial effect lies in that the method can substantially use CVD equipment already verified for use in production of semiconductors or liquid crystal displays (LCDs) in the preparation of the perovskite light absorption layer of solar cells.

In addition, the present invention uses a vacuum deposition method, chemical vapor deposition (CVD), to implement a perovskite light absorption layer that has hitherto been manufactured by a non-vacuum solution method, thereby making it possible to produce a large-area perovskite light absorption layer and consequently solar cells with higher efficiency according to the thin film production method that is advantageous over the conventional solution method.

### BRIEF DESCRIPTION OF THE DRAWINGS

FIG. 1 is a diagram for illustration of a method for preparing a perovskite solar cell light absorption layer according to an embodiment of the present invention.
FIG. 2 is an illustrative diagram of a chemical vapor deposition reaction chamber capable of being used in the method for preparing a perovskite solar cell light absorption layer as shown in FIG. 1.
FIG. 3a shows the surface of the PbIₓ thin film deposited on a TiO₂ thin film by means of the CVD method.
FIG. 3b shows the cross section of the PbIₓ thin film deposited on a TiO₂ thin film by means of the CVD method.
FIG. 4a shows the surface of a metal electrode deposited after forming a CH₃NH₃PbI₃ thin film by supplying MA (methylamine) and an iodine precursor on the PbIₓ thin film deposited by the CVD method.
FIG. 4b shows the cross section of a metal electrode deposited after forming a CH₃NH₃PbI₃ thin film by supplying MA and an iodine precursor on the PbIₓ thin film deposited by the CVD method.
FIG. 5 presents a deep analysis of the manufactured CH₃NH₃PbI₃ thin film using AES (Auger Electron Spectroscopy) .
FIG. 6 presents the measurements of the energy conversion efficiency of the CH₃NH₃PbI₃ thin film manufactured by the CVD method according to the present invention.

### DETAILED DESCRIPTION OF THE DISCLOSURE

As the present invention allows for various changes and numerous embodiments, particular embodiments will be illustrated in the drawings and described in detail. However, the present invention is not limited to the specific embodiments and should be construed as including all the changes, equivalents, and substitutions included in the spirit and scope of the present invention. In the description of the accompanying drawings, the same reference symbols are assigned to the same components.

Although ordinal numbers such as "first", "second", "a", "b", and so forth will be used to describe various components, those components are not limited by the terms. The terms are used only for distinguishing one component from another component. For example, a first component may be referred to as a second component and likewise, a second component may also be referred to as a first component, without departing from the teaching of the inventive concept. The term "and/or" used herein includes any and all combinations of one or more of the associated listed items.

The terminology used herein is for the purpose of describing an embodiment only and is not intended to be limiting of an exemplary embodiment. As used herein, the singular forms are intended to include the plural forms as well, unless the context clearly indicates otherwise. It will be further understood that the terms "comprises" and/or "has" when used in this specification, specify the presence of stated feature, number, step, operation, component, element, or a combination thereof but do not preclude the presence or addition of one or more other features, numbers, steps, operations, components, elements, or combinations thereof.

The terms used herein, including technical and scientific terms, have the same meanings as terms that are generally understood by those skilled in the art, as long as the terms are differently defined. It should be understood that terms defined in a generally-used dictionary have meanings coinciding with those of terms in the related technology. As long as the terms are not defined obviously, they are not ideally or excessively analyzed as formal meanings.

Hereinafter, a detailed description will be given as to the preferred embodiments of the present invention with reference to the accompanying drawings.

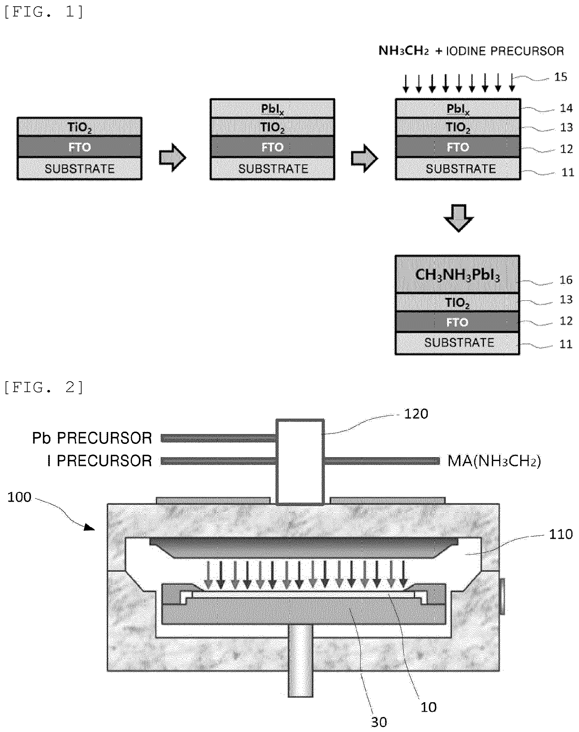

FIG. 1 is a diagram for illustration of a method for preparing a perovskite solar cell light absorption layer according to an embodiment of the present invention.

Referring to FIG. 1, the method for preparing a perovskite solar cell light absorption layer according to an embodiment of the present invention is a preparation method for a perovskite solar cell light absorption layer using the chemical vapor deposition method. In the preparation method, a PbIₓ (1≤x≤2) thin film 14 is formed on a substrate 11 by means of the chemical vapor deposition method. CH₃NH₂ (methylamine) and an iodine precursor 15 are supplied on the PbIₓ (1≤x≤2) thin film 14. Then, a heat treatment is conducted to form a CH₃NH₃PbI₃ thin film 16 having a perovskite structure.

More specifically, the step of forming a PbIₓ thin film may include using, as a lead (Pb) precursor, any one or more selected from tetraethyl-lead, tetramethyl-lead, acetylacetonate-lead(II), and bis(2,2,6,6-tetramethyl-3,5-herptanedionate) lead(II). And, the step of forming a PbIₓ thin film may include using, as an iodine (I) precursor, any one or more selected from iodine (I₂), 6-iodo-1-hexyne, tertiary-butyl iodide, isopropyl iodide, and ethyl iodide.

Further, in the step of forming a PbIₓ thin film, the Pb and I precursors may be supplied into a reaction chamber (100 of Fig. 2) in simultaneous or sequential manner.

Further, in the step of forming a PbIₓ thin film, a canister temperature atmosphere for the Pb or I precursor may be maintained in the range of -20 to 100 °C. The canister temperature is set in a temperature range set to form a vapor pressure appropriate for the smooth supply of the precursor into the reaction chamber. If the temperature is out of this temperature range, the efficiency of forming vapor pressure may decrease proportionally to the extent of deviation.

Further, in the step of forming a PbIₓ thin film, the temperature atmosphere of a precursor supply line for supplying the Pb or I precursor may be maintained in the range from the room temperature to 200 °C.

Further, in the step of forming a PbIₓ thin film, the temperature atmosphere of a substrate for the Pb or I precursor deposited thereon may be maintained in the range of 50 to 300 °C.

Further, the step of forming a PbIₓ thin film may include using a carrier gas in supplying the Pb or I precursor into the reaction chamber, where the carrier gas may be any one of argon (Ar), helium (He) and nitrogen (N₂), or a mixture thereof.

Further, in the step of forming a PbIₓ thin film, the internal pressure of the reaction chamber may be maintained in the range of 1 mTorr to 100 Torr.

Further, in the step of forming a PbIₓ thin film, plasma may be used to increase the deposition rate and quality of the thin film.

Subsequently, in the supplying step, the temperature atmosphere of a supply line of the MA (CH₃NH₂) and the iodine precursor may be maintained in the range from the room temperature to 200 °C.

Further, in the supplying step, the temperature of a substrate for the MA (CH₃NH₂) and the iodine precursor supplied thereto in the range from the room temperature to 250 °C.

Subsequently, in the step of forming a CH₃NH₃PbI₃ thin film, a heat treatment may be conducted at a temperature atmosphere of 100 to 300 °C on the CH₃NH₃PbI₃ thin film deposited through the supplying step.

Further, in the step of forming a CH₃NH₃PbI₃ thin film, a heat treatment may be conducted under vacuum or in one or more gas atmospheres of argon (Ar), nitrogen (N₂), hydrogen (H₂), and helium (He).

On the other hand, a fluorine-doped tin oxide (FTO) thin film 12 and a titanium dioxide (TiO₂) thin film 13 may be sequentially deposited between the substrate 11 and the PbIₓ thin film 14. The substrate 11 may be made of glass, plastic, or the like.

FIG. 2 is an illustrative diagram of a chemical vapor deposition reaction chamber capable of being used in the method for preparing a perovskite solar cell light absorption layer as shown in FIG. 1.

Referring to FIG. 2, a chemical vapor deposition reaction chamber 100 according to this embodiment may be operated to manufacture a solar cell light absorption layer in an internal vacuum atmosphere 110, that is, forming a PbIₓ thin film by means of the chemical vapor deposition method on a substrate placed on a support 30, supplying methylamine and an iodine precursor for deposition on the PbIₓ thin film and then forming a CH₃NH₃PbI₃ thin film through a heat treatment under defined temperature and pressure conditions or in a gas atmosphere.

According to the above-described embodiment, the FTO thin film 12 and the TiO₂ thin film 13 are sequentially deposited on the substrate 11, and the Pb and I precursors are then simultaneously or sequentially supplied into the reaction chamber 100 by the chemical vapor deposition (CVD) method to form the PbIₓ thin film on the TiO₂ thin film 13. Then, methylamine and the iodine precursor 15 are supplied on the PbIₓ thin film 14, and a heat treatment is conducted to form the CH₃NH₃PbI₃ thin film 16 having a perovskite structure.

Further, a light absorption layer formed by the above-described preparation process is used to provide a thin film solar cell with large area and high efficiency relative to the conventional solar cells.

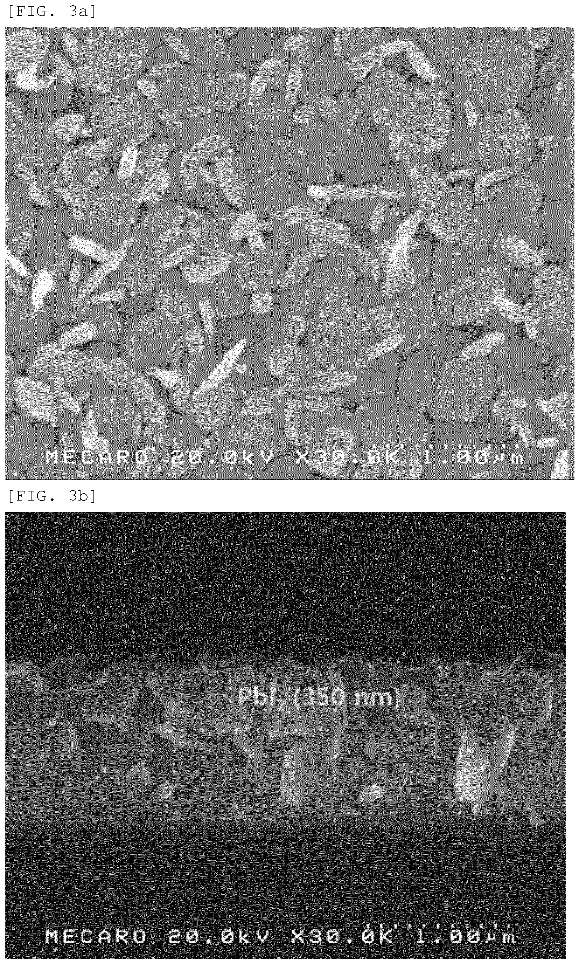

FIG. 3a shows the surface of the PbIₓ thin film deposited on the TiO₂ thin film by means of the CVD method according to this embodiment.

As can be seen from FIG. 3a, according to the present invention, the PbIₓ thin film was obtained to have a very dense surface.

FIG. 3b shows the cross section of the PbIₓ thin film deposited on the TiO₂ thin film by the CVD method according to this embodiment.

As can be seen from FIG. 3b, according to this embodiment, the crystal structure of the PbIₓ thin film deposited by the CVD method was relatively uniform with respect to that of the conventional thin film.

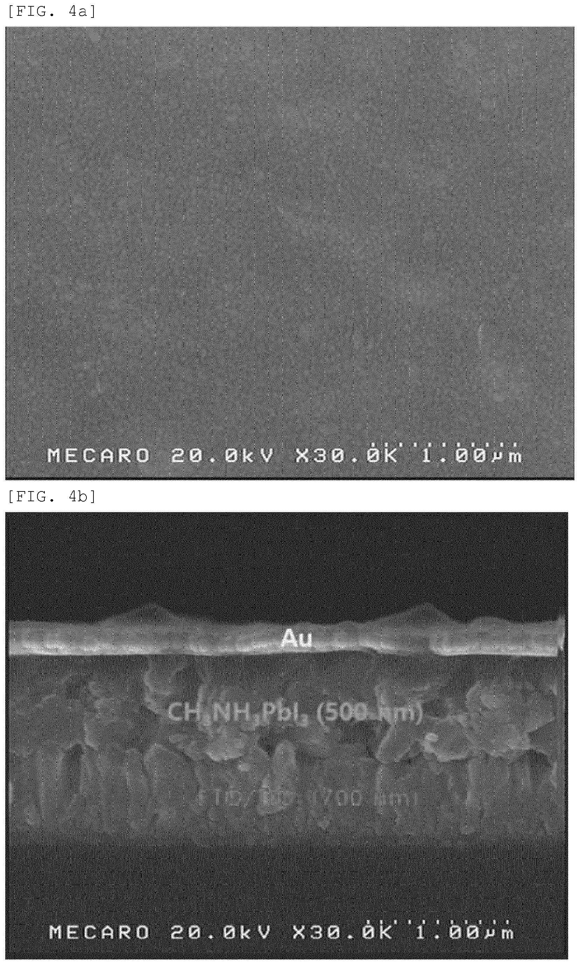

FIG. 4a shows the surface of a metal electrode deposited after forming the CH₃NH₃PbI₃ thin film by supplying MA (methylamine) and an iodine precursor on the PbIₓ thin film deposited by the CVD method.

As can be seen from FIG. 4a, according to this embodiment, the underlying thin film, i.e., the CH₃NH₃PbI₃ thin film was very uniform, so the overlying thin film, i.e., the metal electrode also had a uniform surface. The metal electrode thin film used gold (Au).

FIG. 4b shows the cross section of a metal electrode deposited after forming a CH₃NH₃PbI₃ thin film by supplying MA (methylamine) and an iodine precursor on the PbIₓ thin film deposited by the CVD method.

As can be seen from FIG. 4b, according to this embodiment, the CH₃NH₃PbI₃ thin film formed by supplying MA (methylamine) and the iodine precursor on the PbIₓ thin film was also a highly dense and uniform thin film.

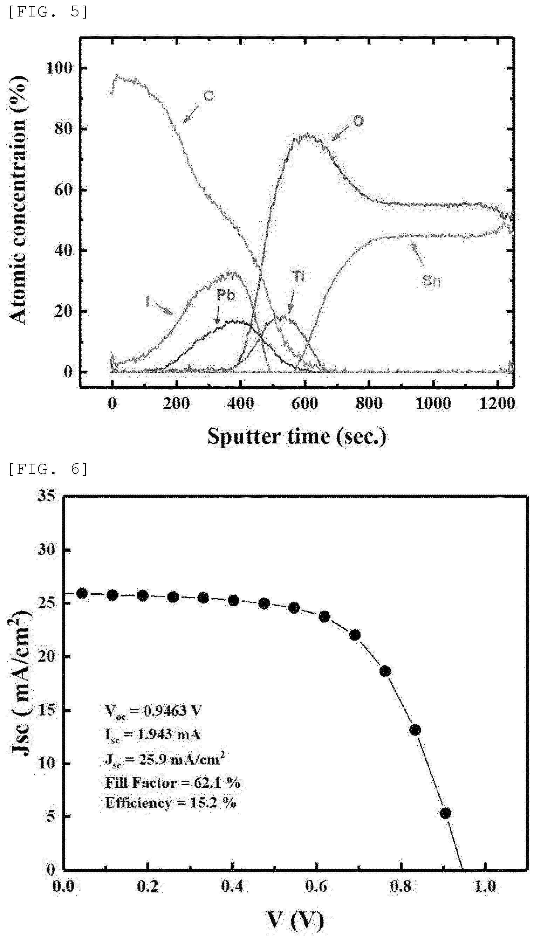

FIG. 5 presents a deep analysis of the CH₃NH₃PbI₃ thin film manufactured by the method of this embodiment using AES (Auger Electron Spectroscopy).

As can be seen from FIG. 5, peaks for Pb and I on the TiO₂ thin film appeared almost at the same positions according to the measurements of the atomic concentration in function of the sputter time, claiming that the CH₃NH₃PbI₃ thin film was normally manufactured by the CVD method according to this embodiment.

FIG. 6 presents the measurements of the energy conversion efficiency of the CH₃NH₃PbI₃ thin film manufactured by the CVD method according to the present invention.

As can be seen from FIG. 6, the perovskite thin film solar cell manufactured by the CVD method according to this embodiment had an energy conversion efficiency of 15.2%.

In other words, the fill factor, corresponding to a value obtained by dividing the power at the maximum power point by the product of the open-circuit voltage (V_{OC}) and the short-circuit current (I_{SC}), was calculated as 62.1%. The heat value (J_{SC}) at the maximum power point was 25.9 mA/cm². And, the size of the specimen used in this embodiment was 2mm x 4mm.

As described above, the aforementioned embodiment of the present invention facilitates the implementation of large-area solar cells, minimizes an issue of deterioration in efficiency over time after the preparation of solar cells, enables the substantial use of the CVD equipment generally available for the preparation of semiconductors, liquid crystal displays (LCDs), or the like, and provides a preparation method for perovskite solar cells with high efficiency relative to the related art.

Although the foregoing description of the present invention has been presented with reference to the examples of the present invention, it may be apparent to those skilled in the art that many modifications and variations can be made to the present invention without departing from the spirits and scope of the present invention disclosed in the following claims and that the scope of the claims of the present invention includes such modifications and variations belonging to the principles of the present invention.

## Claims

1. A method for preparing a perovskite solar cell light absorbing layer using chemical vapor deposition, the method comprising:
forming a PbIₓ (1≤x≤2) thin film on a substrate by means of chemical vapor deposition;
supplying CH₃NH₂ (methylamine) gas and an iodine precursor on the PbIₓ thin film; and
forming a CH₃NH₃PbI₃ thin film having a perovskite structure through heat treatment after the supplying of the CH₃NH₂ (methylamine) gas and the iodine precursor on the PbIₓ (1≤x≤2) thin film.

2. The method according to claim 1, wherein the forming of the PbIₓ thin film includes using, as a Pb precursor, any one or more selected from a group consisting of tetraethyl-lead, tetramethyl-lead, acetylacetonate-lead(II), and bis(2,2,6,6-tetramethyl-3,5-herptanedionate) lead(II).

3. The method according to claim 2, wherein the forming of the PbIₓ thin film includes using, as an I precursor, any one or more selected from a group consisting of iodine (I₂), 6-iodo-1-hexyne, tertiary-butyl iodide, isopropyl iodide, and ethyl iodide.

4. The method according to claim 1, wherein the forming of the PbIₓ thin film includes supplying the Pb precursor and the I precursor into a reaction chamber in simultaneous manner.

5. The method according to claim 1, wherein the forming of the PbIₓ thin film includes supplying the Pb precursor and the I precursor into a reaction chamber in sequential manner.

6. The method according to claim 4 or 5, wherein the forming of the PbIₓ thin film includes maintaining a canister temperature atmosphere for the Pb precursor or the I precursor in a range of -20 to 100 °C.

7. The method according to claim 4 or 5, wherein the forming of the PbIₓ thin film is maintaining a temperature atmosphere of a precursor supply line for supplying the Pb precursor or the I precursor in a range from room temperature to 200 °C.

8. The method according to claim 4 or 5, wherein the forming of the PbIₓ thin film is maintaining a temperature atmosphere of a substrate for the Pb precursor or the I precursor deposited thereon in a range of 50 to 300 °C.

9. The method according to claim 4 or 5, wherein the forming of the PbIx thin film includes using, as a carrier gas, any one of argon (Ar), helium (He) or nitrogen (N₂), or a mixture thereof when supplying the Pb precursor or the I precursor into the reaction chamber.

10. The method according to claim 4 or 5, wherein the forming of the PbIx thin film includes maintaining a pressure atmosphere in the reaction chamber in a range of 1 mTorr to 100 Torr.

11. The method according to claim 4 or 5, wherein the forming of the PbIx thin film includes using plasma in order to increase a deposition rate and quality of the thin film.

12. The method according to claim 1, wherein the forming of the CH₃NH₃PbI₃ thin film includes supplying MA (CH₃NH₂) and an iodine (I) precursor on the PbIₓ thin film into a reaction chamber in simultaneous manner.

13. The method according to claim 1, wherein the forming of the CH₃NH₃PbI₃ thin film includes supplying MA (CH₃NH₂) and an iodine (I) precursor on the PbIₓ thin film into a reaction chamber in sequential manner.

14. The method according to claim 12 or 13, wherein the forming of the CH₃NH₃PbI₃ thin film includes using, as an iodine (I) precursor, any one or more selected from a group consisting of iodine (I₂), 6-iodo-1-hexyne, tertiary-butyl iodide, isopropyl iodide, and ethyl iodide.

15. The method according to claim 1, wherein the supplying includes maintaining a temperature atmosphere of a supply line of MA (methylamine, CH₃NH₂) and an iodine precursor in a range from room temperature to 200 °C.

16. The method according to claim 1, wherein the supplying includes maintaining a temperature atmosphere of a substrate for MA (methylamine, CH₃NH₂) and an iodine precursor supplied thereto in a range from room temperature to 250 °C.

17. The method according to claim 1, wherein the forming of the CH₃NH₃PbI₃ thin film is conducting a heat treatment at a temperature of 100 to 300 °C on the CH₃NH₃PbI₃ thin film deposited through the supplying.

18. The method according to claim 17, wherein the forming of the CH₃NH₃PbI₃ thin film includes conducting a heat treatment under vacuum or in one or more gas atmospheres of argon (Ar), nitrogen (N₂), hydrogen (H₂), and helium (He) .
